# EUROPEAN PATENT APPLICATION

(11) **EP 4 036 970 A1**
(43) Date of publication of application: **03.08.2022**
(21) Application number: 21154146.1
(22) Date of filing: 28.01.2021
(51) Int. Cl.: H01L 25/075, H01L 27/15, H01L 33/62, H01L 25/16

(54) **LED DISPLAY**

(71) Applicant: Innostar Service Inc., Taichung City 437 (TW); Naviance Semiconductor Limited, Zhubei City,Hsinchu County 302 (TW)
(72) Inventor: WU, MENG-CHIH, 437 Taichung City (TW); TIEN, CHIEN-KUO, 302 Hsinchu County (TW); LIN, CHUN-CHUNG, 302 Hsinchu County (TW)
(74) Representative: Lang, Christian

(57) **Abstract**

A display(10) includes micro LEDs (39) connected to a color conversion layer (40) and driver ICs (11) connected to the micro LEDs (39) via an electrically connecting layer (28). Each micro LEDs (39) includes an N pad (36) and a P pad (37). The micro LEDs (39) emit light of a same color, and the color conversion layer (40) converts the light into various colors. The electrically connecting layer (28) includes elongated negative electrodes (24) connected to the N pads (36) and elongated positive electrodes (25) connected to the P pads (37). Each driver IC (11) includes a first group of bonding pads (15) on a face (13), a second group of bonding pads (17) on an opposite face (14), and conductors (16) for connecting the first group of bonding pads (15) to the second group of bonding pads (17). Each bonding pad (15) in the first group is connected to an elongated negative or positive electrode (24, 25). The circuit board (20) is connected to the second group of bonding pads (17) of each driver IC (11).

## Description

### BACKGROUND OF INVENTION

### 1. FIELD OF INVENTION

The present invention relates to a display and, more particularly, to an LED display.

### 2. RELATED PRIOR ART

A light-emitting diode ("LED") display includes light-emitting diodes attached to a substrate by glue. Each of the light-emitting diodes is in the form of a die cut from a wafer. The attachment of the light-emitting diodes to the substrate is called "die bonding."

A light-emitting diode in the form of a flip chip includes a positive electrode P and a negative electrode N on a same side, and each of the positive and negative electrodes is covered by a block of solder. The light-emitting diode in the form of a flip chip is cut and bonded before it can be electrically connected to a circuit board.

Pixels-per-inch ("PPI") is often used to describe the resolution of a display. However, the size of a micro light-emitting diode is smaller than 100 µm, about 1% of the size of a regular light-emitting diode. In the making of micro light-emitting diodes, problems are encountered.

For example, millions of micro light-emitting diodes are transferred to a glass substrate of a thin film transistor ("TFT") or a circuit board from an original substrate made of sapphire or gallium arsenide for example. Transfer of such a large amount of micro light-emitting diodes is too difficult for conventional machines that are suitable for making average light-emitting diodes.

Moreover, an even larger amount of contact points have to be handled to attach such a large amount of micro light-emitting diodes to a circuit board. A display needs complicated wiring to connect micro light-emitting diodes at a high resolution. Such complicated wiring required a precise and expansive process and are not good for the transfer of such a large amount of micro light-emitting diodes. Hence, the rate of defects in the making of the displays equipped with micro light-emitting diodes is high.

The present invention is therefore intended to obviate or at least alleviate the problems encountered in the prior art.

### SUMMARY OF INVENTION

It is the primary objective of the present invention to provide an inexpensive and high-solution display.

To achieve the foregoing objective, the display includes micro light-emitting diodes connected to a color conversion layer and driver integrated circuits connected to the micro light-emitting diodes via an electrically connecting layer. Each of the micro light-emitting diodes includes an N pad and a P pad. The micro light-emitting diodes emit light beams of a same color. The color conversion layer converts the light beams into various colors. The electrically connecting layer includes elongated negative electrodes connected to the N pads and elongated positive electrodes connected to the P pads. Each of the driver integrated circuits includes a first group of bonding pads on a face, a second group of bonding pads on an opposite face, and conductors for connecting the first group of bonding pads to the second group of bonding pads. Some of the bonding pads in the first group are connected to the elongated negative electrodes. The remaining ones of the bonding pads in the first group are connected to the elongated positive electrodes. The circuit board is connected to the second group of bonding pads of each of the driver integrated circuits.

Other objectives, advantages and features of the present invention will be apparent from the following description referring to the attached drawings.

### BRIEF DESCRIPTION OF DRAWINGS

The present invention will be described via detailed illustration of the preferred embodiment referring to the drawings wherein:
FIG. 1 is a perspective view of a driver IC according to the preferred embodiment of the present invention;
FIG. 2 is a perspective view of a wafer including light-emitting units;
FIG. 3 is a top view of an electrically connecting layer and the light-emitting units shown in FIG. 2;
FIG. 4 is a perspective view of the driver IC shown in FIG. 1 electrically connected to the light-emitting units via the electrically connecting layer shown in FIG. 3;
FIG. 5 is an enlarged, partial and cross-sectional view of a semi-product of a display equipped with the micro light-emitting diodes shown in FIG. 4;
FIG. 6 is an enlarged, partial and cross-sectional view of a completed product of the display shown in FIG. 5;
FIG. 7 is a sketch of a layout of one of the micro light-emitting diodes shown in FIG. 2; and
FIG. 8 is a front view of a display equipped with the micro light-emitting diodes shown in FIG. 2.

### DETAILED DESCRIPTION OF PREFERRED EMBODIMENT

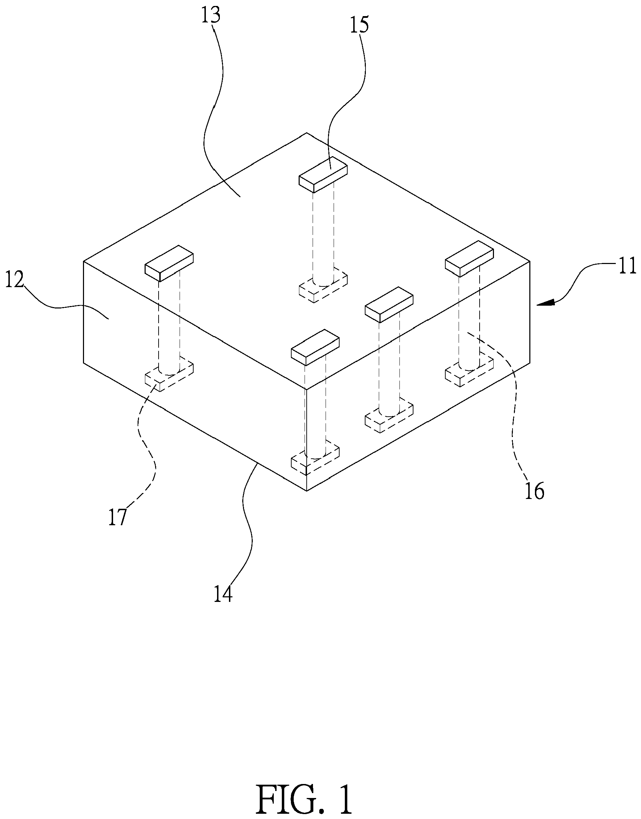

Referring to FIGS. 1 through 7, a display 10 includes at least one circuit board 20 and at least one group of micro light-emitting diodes 39 according to the preferred embodiment of the present invention.

Referring to FIG. 1, a driver integrated circuit ("IC") 11 includes a base 12 formed with two opposite faces 13 and 14. There are bonding pads 15 on the face 13 of the base 12. There are bonding pads 17 on the face 14 of the base 12. The bonding pads 17 are shaped and located corresponding to the bonding pads 15. A through-silicon via ("TSV") technique is used to make conductors 16 in the base 12. Each of the conductors 16 connects a corresponding one of the bonding pads 15 to a corresponding one of the bonding pads 17. Thus, the faces 13 and 14 of the base 12 of the driver IC 11 are electrically connected to each other.

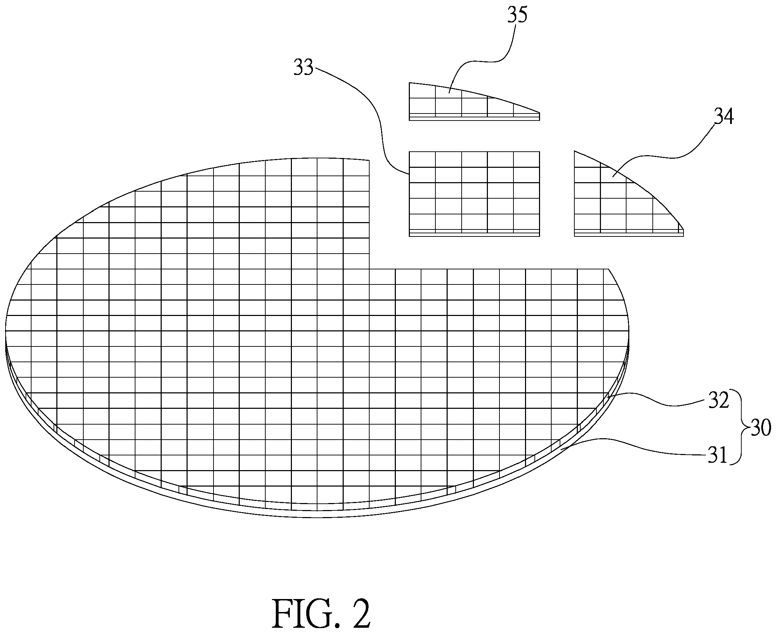

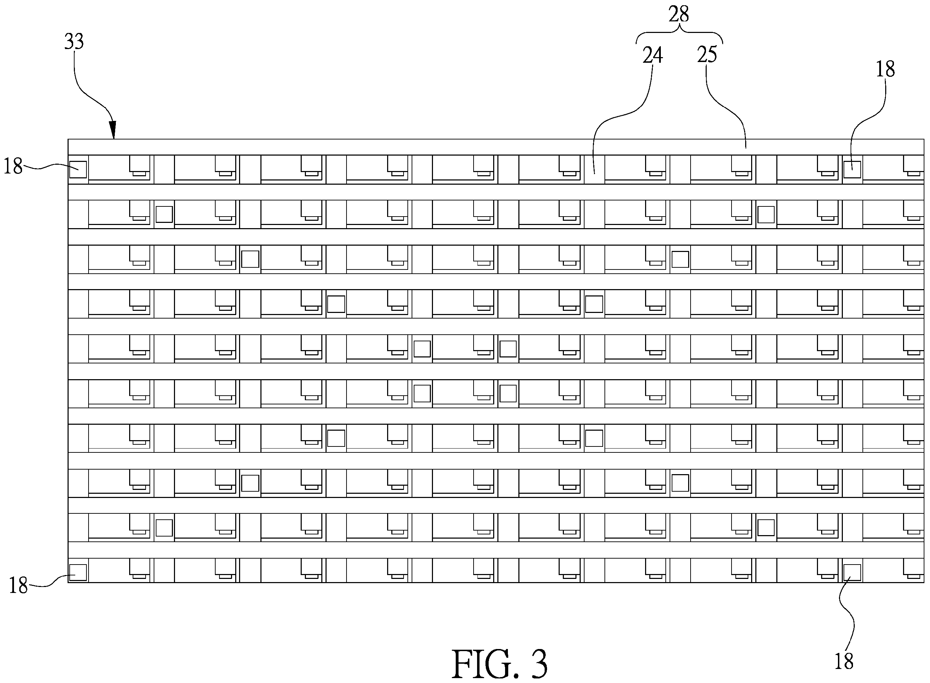

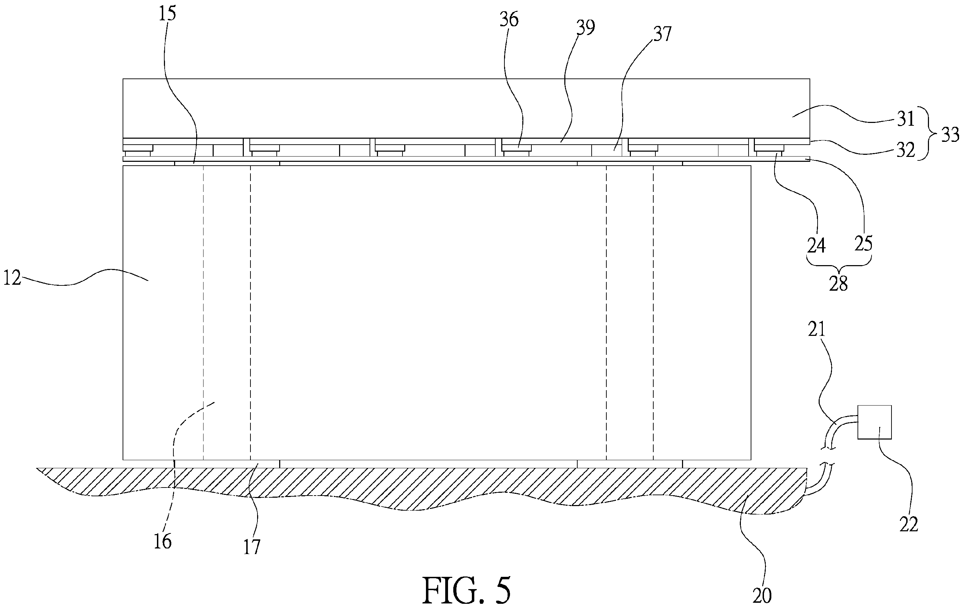

Referring to FIG. 2, an original substrate 30 includes a crystal layer 31 of sapphire for example grown on an extensive layer 32 by an epitaxy technique. The extensive layer 32 includes structures of the micro light-emitting diodes 39. The original substrate 30 is cut into light-emitting units 33 of a desired size, with some residual materials 34 and 35 to be disposed of. Each of the light-emitting units 33 includes light-emitting diodes 29 (FIGS. 3 and 5).

Referring to FIG. 3, each of the light-emitting units 33 is electrically connected to a driver IC 11 through an electrically connecting layer 28. The electrically connecting layer 28 includes two groups of pins 18, a group of elongated negative electrodes 24 and a group of elongated positive electrodes 25. Each of the elongated negative electrodes 24 and each of the elongated positive electrodes 25 extend like two skew lines, i.e., the elongated negative electrodes 24 are not electrically connected to the elongated positive electrodes 25. The pins 18 in the first group are arranged along a line extending from the left top corner of the electrically connecting layer 28 to the right bottom corner. The pins 18 in the second group are arranged along a line extending from the right top corner of the electrically connecting layer 28 to the left bottom corner. The pins 18 in the first and second groups are electrically connected to the elongated negative electrodes 24.

The light-emitting units 33 are electrically connected to the electrically connecting layer 28 by various etching techniques such as mask techniques or reticle techniques. A so-called etching technique is a technique that produces or deposits layers of different materials and etches each of the layers into a circuit.

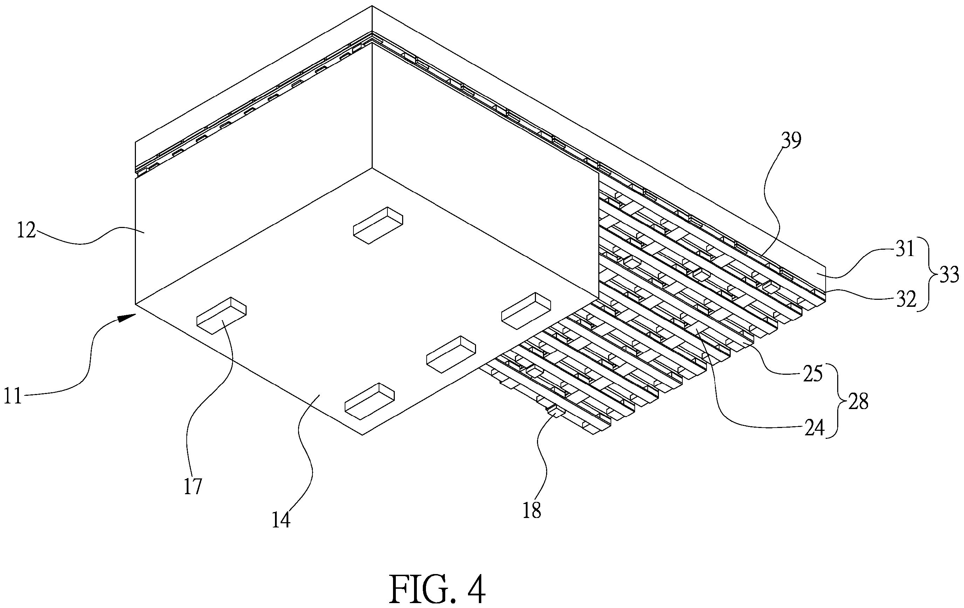

Referring to FIG. 4, the face 13 of the driver IC 11 is electrically connected to some of the pins 18 so that the driver IC 11 is electrically connected to the elongated negative electrodes 24. The face 13 of the driver IC 11 is electrically connected some of the pins 18 so that the driver IC 11 is electrically connected to the elongated positive electrodes 25. The bonding pads 17, which are formed on the face 14 of the driver IC 11, are electrically connected to the light-emitting units 33 through the conductors 16.

The micro light-emitting diodes 39 are formed in the extensive layer 32, which is grown on the crystal layer 31. The extensive layer 32 is supported on the driver IC 11.

Referring to FIG. 5, each of the micro light-emitting diodes 39 includes an N pad 36 and a P pad 37. The N pad 36 and the P pad 37 are pointed at the driver IC 11. The N pads 36 of the micro light-emitting diodes 39 are electrically connected to the elongated negative electrodes 24. The P pads 37 of the micro light-emitting diodes 39 are electrically connected to the elongated positive electrodes 25. The bonding pads 17 are electrically connected to the circuit board 20 so that the light-emitting units 33, the electrically connecting layer 28, the driver IC 11 and the circuit board 20 together form an electric loop to energize the micro light-emitting diodes 39.

The circuit board 20 is a printed circuit board ("PCB"), a printed wiring board ("PWB"), a polyimide ("PI") board or a glass substrate. At least one cable 21 is used to electrically connect the circuit board 20 to at least one controller 22. The controller 22 is programmable to turn on and off the driver IC 11 through the electrically connecting layer 28.

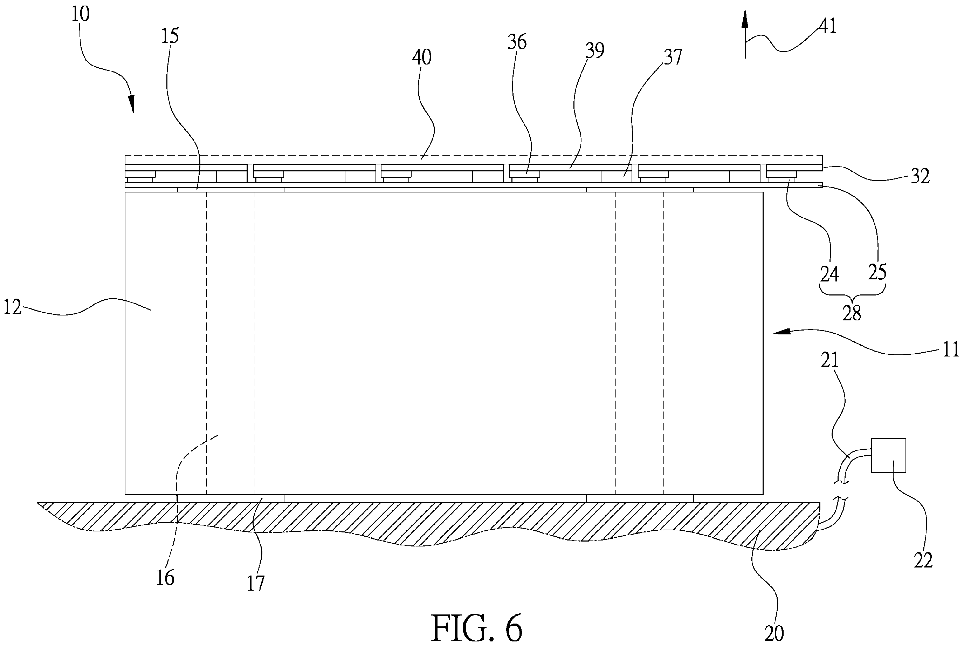

Referring to FIG. 6, a Laser-Lift-Off ("LLO") technique is used to separate the extensive layer 32 from the crystal layer 31. Thus, the group of micro light-emitting diodes 39 is still connected to the driver IC 11 after the separation.

A color conversion layer 40 is laid on the micro light-emitting diodes 39. The color conversion layer 40 is preferably a quantum dot color filter ("QDCF").

The micro light-emitting diodes 39 emit light beams to the color conversion layer 40 as indicated by an arrow head 41 when the circuit board 20 is turned on. The color conversion layer 40 turns the light beams of a color into light beams of red, green and blue. The light beams of red, green and blue then go out of the display 10. The controller 22 is used to correct brightness of the micro light-emitting diodes 39 so that the display shows desired colors and brightness.

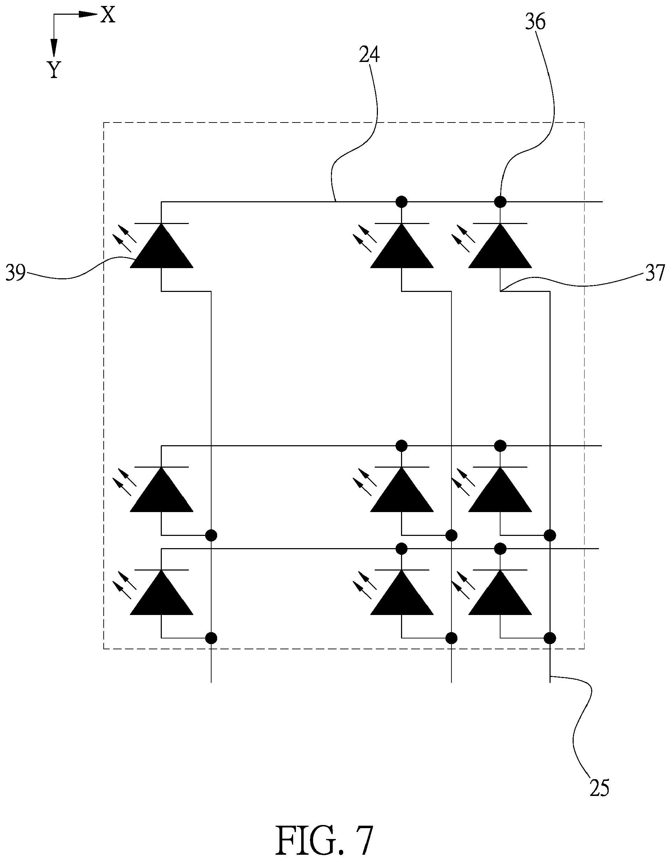

Referring to FIG. 7, each of the elongated negative electrodes 24 extends parallel to an X-axis so that the elongated negative electrodes 24 are not connected to one another. Each of the elongated positive electrodes 25 extends parallel to a Y-axis so that the elongated positive electrodes 25 are not connected to one another. Some of the micro light-emitting diodes 39 do not emit light beams even if one of the elongated negative electrodes 24 transmits electricity to the N pads 36 of these micro light-emitting diodes 39. Similarly, some of the micro light-emitting diodes 39 do not emit light beams even if one of the elongated positive electrodes 25 transmits electricity to the P pads 37 of these micro light-emitting diodes 39. Thus, only a micro light-emitting diode 39 that is connected to one of the elongated negative electrodes 24 and one of the elongated positive electrodes 25 cast a light beam. The layout of the display 10 helps control a current or voltage through each of the light-emitting diodes 39.

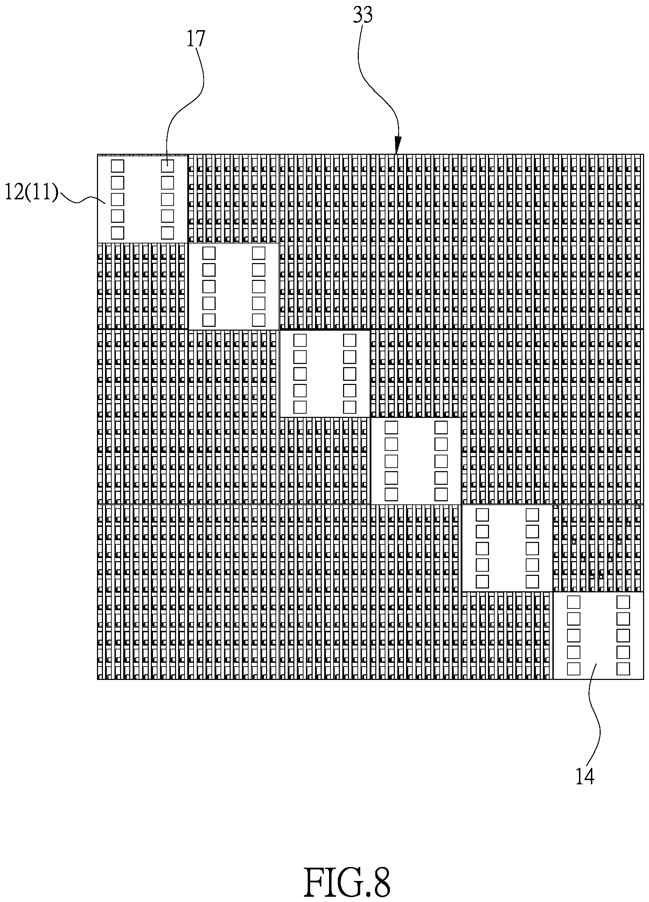

Referring to FIG. 8, several light-emitting units 33 are used together to provide a display of a large size. Due to the use of the above-mentioned layout, multiple light-emitting units 33 are electrically connected to the faces 13 of the bases 12 of multiple driver ICs 11. The face 13. The face 14 of the bases 12 of the driver ICs 11 are electrically connected to the bonding pads 17. Thus, the driver ICs 11 can control a current or voltage through each of the light-emitting diodes 39.

For example, multiple light-emitting units 33 are used together to provide a value of PPI of 180×180 and each driver IC 11 provides a value of PPI of 30x30. Thus, it takes only six driver ICs 11 that are arranged along a diagonal line of the array of light-emitting units 33 to control all the micro light-emitting diodes 39 of the display equipped 10.

In another embodiment, the display 10 does not include any color conversion layer 40, i.e., QDCF. Instead, each driver IC 11 of the display 10 is electrically connected to three groups of micro light-emitting diodes. The micro light-emitting diodes in the first group emit red light. The micro light-emitting diodes in the second group emit green light. The micro light-emitting diodes in the third group emit blue light. Each driver IC 11 is electrically connected to the circuit board 20. The color conversion layer 40 is not essential when techniques for massive transfer of micro light-emitting diodes mature. The display 10 is reduced by omitting the color conversion layer 40.

As discussed above, the display 10 is advantageous in several aspects. Firstly, the light-emitting units 33, each of which includes multiple micro light-emitting diodes 39, are cut from the wafer. There is no need to cut the micro light-emitting diodes 39, one by one, from the wafer. There is no need to transfer a very large number of separated micro light-emitting diodes 39. There is no need to precisely locate the micro light-emitting diodes 39, one by one.

Secondly, the process for electrically connecting the driver ICs 11 to the micro light-emitting diodes 39 is simplified. The related cost is reduced.

Thirdly, the precision of connecting the micro light-emitting diodes 39 to the electrode strips 24 and 25 is improved. The yield of the making of displays is increased.

The present invention has been described via the illustration of the preferred embodiment. Those skilled in the art can derive variations from the preferred embodiment without departing from the scope of the present invention. Therefore, the preferred embodiment shall not limit the scope of the present invention defined in the claims.

## Claims

1. A display comprising:
a color conversion layer;
micro light-emitting diodes each of which comprises an N pad and a P pad and is attached to the color conversion layer, wherein the micro light-emitting diodes emit light beams of a same color, wherein the color conversion layer converts the light beams into various colors;
an electrically connecting layer comprising elongated negative electrodes electrically connected to the N pads and elongated positive electrodes electrically connected to the P pads;
driver integrated circuits each of which comprises a first group of bonding pads on a face, a second group of bonding pads on an opposite face, and conductors electrically connecting the first group of bonding pads to the second group of bonding pads, wherein some of the bonding pads in the first group are electrically connected to the elongated negative electrodes, and the remaining ones of the bonding pads in the first group are electrically connected to the elongated positive electrodes; and
a circuit board electrically connected to the second group of bonding pads of each of the driver integrated circuits.

2. The display according to claim 1, wherein each of the elongated negative electrodes and each of the elongated positive electrodes extend like two skew lines.

3. The display according to claim 1, wherein the electrically connecting layer comprises a first group of pins electrically connected to the elongated negative electrodes and a second group of pins electrically connected to the elongated negative electrodes.

4. The display according to claim 3, wherein the pins in the first group are arranged along a first line, wherein the pins in the second group are arranged along a second line intersecting the first line.

5. The display according to claim 1, wherein the color conversion layer is a quantum dot color filter.

6. An light-emitting diodes display comprising:
a group of micro light-emitting diodes for emitting red light, another group of micro light-emitting diodes for emitting green light, and another group of micro light-emitting diodes for emitting blue light, wherein each of the micro light-emitting diodes in the groups comprises an N pad and a P pad;
an electrically connecting layer comprising:
elongated negative electrodes electrically connected to the N pads of the micro light-emitting diodes; and
elongated positive electrodes electrically connected to the P pads of the micro light-emitting diodes;
driver integrated circuits each of which comprises a first group of bonding pads on a face, a second group of bonding pads on an opposite face, and conductors electrically connecting the first group of bonding pads to the second group of bonding pads, wherein some of the bonding pads in the first group are electrically connected to the elongated negative electrodes, and the remaining ones of the bonding pads in the first group are electrically connected to the elongated positive electrodes; and
a circuit board electrically connected to the second group of bonding pads of each of the driver integrated circuits.

7. The display according to claim 6, wherein each of the elongated negative electrodes and each of the elongated positive electrodes extend like two skew lines.

8. The display according to claim 6, wherein the electrically connecting layer comprises a first group of pins electrically connected to the elongated negative electrodes and a second group of pins electrically connected to the elongated negative electrodes.

9. The display according to claim 8, wherein the pins in the first group are arranged along a first line, wherein the pins in the second group are arranged along a second line intersecting the first line.
